Europäisches Patentamt

European Patent Office

Office européen des brevets

(19)

(11) Veröffentlichungsnummer: **0 226 813 B1**

(12) # EUROPÄISCHE PATENTSCHRIFT

(45) Veröffentlichungstag der Patentschrift: **28.08.91**

(51) Int. Cl.⁵: **H03L 7/18**

(21) Anmeldenummer: **86115907.7**

(22) Anmeldetag: **13.11.86**

(54) Synthesizer mit Summenkompensation.

(30) Priorität: **14.12.85 DE 3544371**

(43) Veröffentlichungstag der Anmeldung:
**01.07.87 Patentblatt 87/27**

(45) Bekanntmachung des Hinweises auf die
Patenterteilung:
**28.08.91 Patentblatt 91/35**

(84) Benannte Vertragsstaaten:
**FR GB**

(56) Entgegenhaltungen:
**EP-A- 0 073 699**   **EP-A- 0 125 790**
**EP-A- 0 147 307**   **FR-A- 2 196 549**
**GB-A- 2 095 444**   **GB-A- 2 097 206**

(73) Patentinhaber: **Wandel & Goltermann GmbH & Co**
**Postfach 45 Mühleweg 5**
**W-7412 Eningen u.A.(DE)**

(72) Erfinder: **Rudolph, Georg, Dipl.-Ing.**
**Albert Schweitzer Weg 9**
**W-7412 Eningen u. A.(DE)**

(74) Vertreter: **Kucher, Hans**
**Postfach 45 Mühleweg 5**
**W-7412 Eningen u.A.(DE)**

EP 0 226 813 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung bezieht sich auf einen Generator gemäß dem Oberbegriff des Anspruchs 1. Ein solcher Generator ist beispielsweise aus DE-C-2 240 216 bekannt.

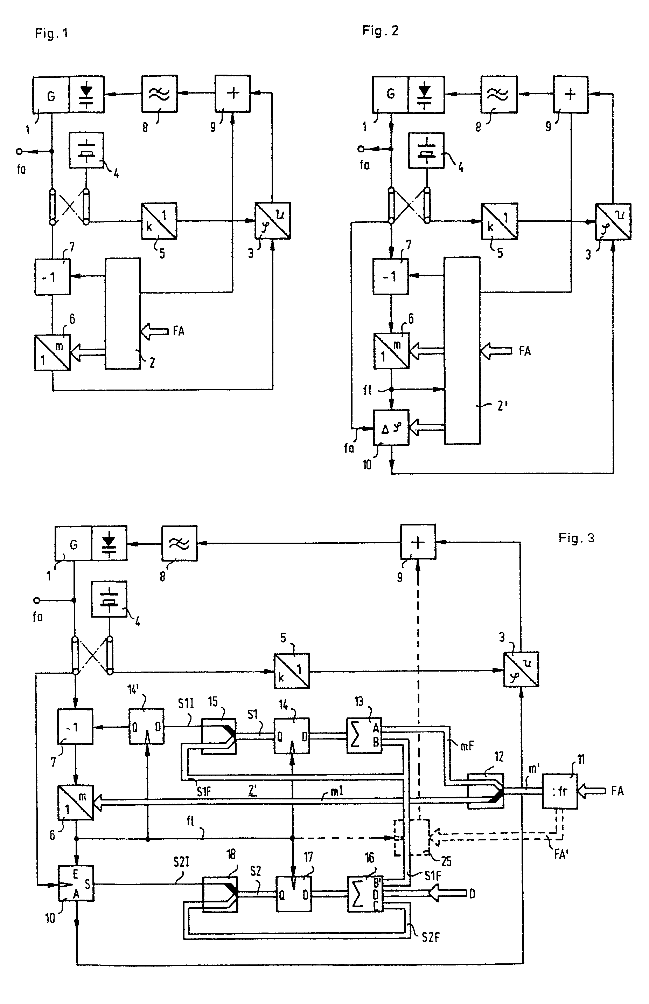

Figur 1 zeigt das vereinfachte Prinzipschaltbild der gattungsgemäßen Anordnung. Die Ausgangsfrequenz fa wird von einem in einer phasengerasteten Frequenzregelschleife (PLL) liegenden spannungsgesteuerten Oszillator 1 (VCO) nach Maßgabe einer in eine Logik- und Rechenschaltung 2 eingebbaren Frequenzinformation FA erzeugt. Die Steuerspannung $U_{st}$ für den VCO liefert ein Phasenmesser 3, dem eine aus einer Normalfrequenzquelle 4 über einen festen Frequenzteiler 5 abgeleitete Referenzfrequenz fr und eine aus der Ausgangsfrequenz fa des Oszillators 1 abgeleitete, im zeitlichen Mittel gleiche Frequenz zugeführt sind. Letztere wird von einem Frequenzteiler 6 mit einstellbarem ganzzahligem Frequenzteilungsverhältnis m geliefert. Dem Frequenzteiler 6 ist ein Impulssubtrahierer 7 vorgeschaltet, der bei seiner Betätigung durch jeweils einen Steuerimpuls jeweils eine Periode (einen Impuls) des ihr vom Ausgang des Oszillators 1 zugeführten Impulszuges unterdrückt, wobei sich dann für die Gesamtanordnung 6,7 (vorübergehend) das Frequenzteilungsverhältnis m + 1 ergibt. Die Logik- und Rechenschaltung 2 stellt je nach der ihr eingegebenen Frequenzinformation FA den Frequenzteiler 6 ein und betätigt die subtrahierende Impulsbewertungsschaltung 7 in der Weise, daß sich im zeitlichen Mittel ein zwischen m und m + 1 liegendes gebrochenes Frequenzteilungsverhältnis m' = fa : fr einstellt. Dabei ergeben sich aber langsame Schwankungen der VCO-Steuerspannung und damit Schwankungen der Ausgangsfrequenz fa (Störlinien), die sich nur durch Siebung der VCO-Steuerspannung mittels eines Schleifenfilters 8 unter Inkaufnahme einer sehr langen Einschwingdauer bei Frequenzwechsel oder durch aufwendige Kompensation der Steuerspannungsschwankung mit Hilfe einer Kompensationsspannung $U_K$ beseitigen lassen, die die Logik- und Rechenschaltung 2 erzeugt und die sie über einen analogen Summierer 9 in den PLL-Regelkreis einspeist.

Der Erfindung liegt die Aufgabe zugrunde, bei einem Generator der eingangs genannten Art mit hoher Referenzfrequenz und großer Frequenzauflösung den Aufwand zu verringern und zwecks leichterer Aussiebbarkeit der an Phasenmesserausgang auftretenden Störlinien deren Frequenz zu erhöhen.

Diese Aufgabe wird durch die im Anspruch 1 angegebenen Merkmale gelöst. Auf diese Weise verlagert sich der Hauptaufwand vom Analogteil des Gerätes in dessen digitale Logik- und Rechenschaltung, und es treten hauptsächlich nur Störlinien mit höherer Frequenz auf. Hierzu wird der durch die gebrochene Frequenzteilung an sich bedingte Phasenfehler laufend berechnet und sein Wert durch gegensinniges Verschieben der Phase des dem Phasenmesser zugeführten, aus dem Ausgangssignal abgeleiteten Signales kompensiert oder auf einem sehr kleinen Wert gehalten. Die Grenzfrequenz des Phasenregelkreises kann somit höher als die durch die gebrochene Frequenzteilung erzeugte Störfrequenz dimensioniert werden, jedoch höchstens so hoch, daß die Störlinien höherer Frequenz noch unterdrückt werden.

Aus der DE-A-32 10 048 ist nun zwar eine Impulsverzögerungskompensation für Frequenzsynthesizer bekannt, die jede störende Schwankung der Ausgangsspannung des Phasendetektors vermeiden soll. Dazu dient dort eine analog einstellbare Impulsverzögerungseinrichtung, die jeden Ausgangsimpuls eines einem Eingang des Phasendetektors vorgeschalteten umschaltbaren Frequenzteilers, der von seiner zeitlichen Soll-Lage abweicht, um ein individuelles Maß verzögert, so daß er am Eingang des Phasendetektors in seiner zeitlichen Soll-Lage erscheint.

Die Erfindung ist nachstehend anhand der in den Figuren 2 bis 7 dargestellten Ausführungsbeispiele erläutert. Hierbei zeigt

Fig. 2 das Prinzipschaltbild der Erfindung,

Fig. 3 das Blockschaltbild eines ersten Ausführungsbeispieles mit einem Impulssubtrahierer und einem Phasenschieber,

Fig. 4 ein Schaubild des zeitlichen Verlaufes des Phasenfehlers der dem Phasenmesser 3 zugeführten Ausgangsspannung des Schieberegisters 10 bzw. des Wechselanteiles der ungefilterten VCO-Steuerspannung,

Fig. 5 das Blockschaltbild eines zweiten Ausführungsbeispieles mit einem flink umsteuerbaren Frequenzteiler,

Fig. 6 ein Schaltbild der in der Anordnung gemäß Figur 5 enthaltenen Differenzierschaltung 20 und

Fig. 7 einen Ausschnitt aus einem Blockschaltbild einer Weiterbildung der in den Figuren 3 und 5 dargestellten Anordnungen mit einer logik- bzw. rechnergesteuerten Kompensationsspannungserzeugung.

Die in Figur 2 im Prinzip dargestellte Erfindung unterscheidet sich von der in Figur 1 dargestellten bekannten Anordnung im wesentlichen durch eine anders ausgebildete und anders arbeitende Logik- und Rechenschaltung 2 und durch eine Anordnung 10 zum Phasenschieben bzw. Impulsverzögern. Letztere ist zwischen den Ausgang des einstellbaren Frequenzteilers 6 und den einen Eingang des Phasenmessers 3 eingefügt und wird von der Logik- und Rechenschaltung 2' in einer anhand der Figur 3 näher erläuterten Weise gesteuert.

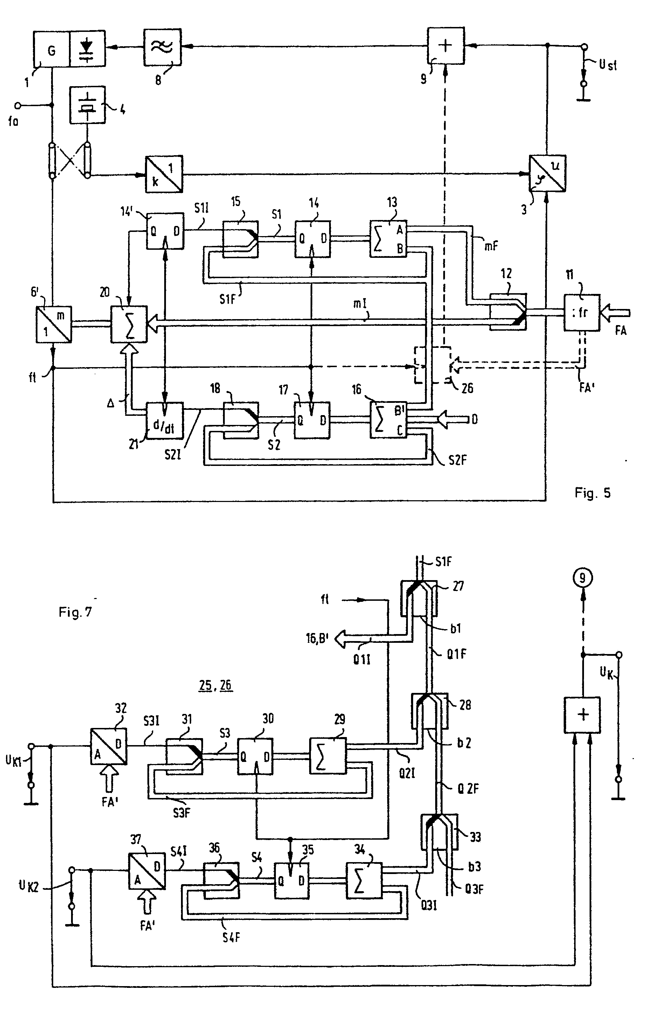

In dem in Figur 3 dargestellten Blockschaltbild des ersten Ausführungsbeispieles ist die im Prinzipschaltbild der Figur 2 enthaltene Logik- und Rechenschaltung 2'detailliert dargestellt. Sie besteht aus einem Schaltungsteil 11 zur Informationseingabe und -aufbereitung, einer Weiche 12 und zwei gleichartigen getakteten Schaltungsgruppen mit jeweils einer Summierschaltung 13,16, einem Zwischenspeicher 14,17 und einer aus einem Quantisierer mit der Stufenhöhe eins bestehenden Weichenschaltung 15, 18. Letztere zwei Schaltungsgruppen bilden jeweils aktuelle Summen S1 bzw. S2 unter Verwendung eines aus dem vorhergehenden Takt stammenden Summanden S1F bzw. S2F. (Dasselbe gilt für die gleichartigen Schaltungsgruppen in den Figuren 5 und 7).

Die Information FA über die gewünschte Ausgangsfrequenz fa wird in den Schaltungsteil 11 eingegeben, der daraus durch Division der Ausgangsfrequenz fa mit der aus der Referenzfrequenzquelle 4 über den festen Frequenzteiler 5 abgeleiteten, dem Phasenmesser 3 zugeführten Referenzfrequenz fr das notwendige gebrochene Frequenzteilungsverhältnis m' = fa : fr ermittelt. Die Weichenschaltung 12 zerlegt m' in einen ganzzahligen Anteil ml, auf den das Frequenzteilungsverhältnis m des Frequenzteilers 6 eingestellt wird, und in einen gebrochenen Anteil mF, aus dem eine vorübergehende Umschaltung der frequenzteilenden Gesamtanordnung 6,7 auf das Frequenzteilungsverhältnis m + 1 abgeleitet wird. Hierzu wird eine in dem Zwischenspeicher 14 stehende erste Summe S1 von der Weichenschaltung 15 in einen gebrochenen Anteil S1F und in einen ganzzahligen Anteil S1I zerlegt (S1 = S1F + S1I). Tritt nun ein ganzzahliger Wert S1I = 1 auf, so wird der Impulssubtrahierer betätigt, wodurch ein vom Oszillator 1 kommender Impuls unterdrückt wird, so daß in der betreffenden Taktperiode das Frequenzteilungsverhältnis m = ml + 1 wirksam ist. Bleibt dagegen S1I = 0, so verbleibt es in der betreffenden Taktperiode beim Frequenzteilungsverhältnis m = ml. Die in einer Taktperiode im Zwischenspeicher 14 stehende erste Summe S1 wird in der vorhergehenden Taktperiode von der Summierschaltung 13 aus dem gebrochenen Anteil mF des notwendigen Frequenzteilungsverhältnisses m' und dem in dieser vorhergehenden Taktperiode festgestellten gebrochenen Anteil S1F gebildet und vorbereitend an den Eingang des Zwischenspeichers 14 gelegt, die bei Eintreffen des Taktes an den Ausgang übernommen wird.

In ähnlicher Weise arbeitet die zweite Summier- und Weichenschaltung 16,17,18. Sie bildet eine zweite Summe S2 aus dem in der vorhergehenden Taktperiode in ihr aufgetretenen gebrochenen Anteil S2F und aus dem in der vorhergehenden Taktperiode ausgetretenen Anteil S1F der ersten Summier- und Weichenschaltung 13,14,15, zerlegt sie in einen ganzzahligen Anteil S2I und den gebrochenen Anteil S2F und betätigt bei S2I = 1 den mit der Ausgangsfrequenz fa getakteten Phasenschieber 10. Die Logik- und Rechenschaltung 2' betätigt einen nicht näher dargestellten Umschalter des Phasenschiebers 10 so, daß er diesen auf seinen kleineren Wert einstellt, wenn der ganzzahlige Anteil S2I der zweiten Summe S2 Null ist, und daß er den Phasenschieber 10 auf einen größeren Wert einstellt, wenn S2I den Wert 1 aufweist, wobei der Unterschied einer Taktperiode 1:fa der Ausgangsfrequenz fa entspricht.

Das in Figur 3 dargestellte erste Ausführungsbeispiel kann in der Weise abgewandelt werden, daß die Stufenhöhe der Weiche 18 der zweiten getakteten Schaltungsgruppe 16,17,18 den Wert p aufweist (p ganzzahlig und $\geq$ 1). In diesem Fall ist S2I entweder gleich 0, wenn S2 < p, oder gleich 1, wenn S2 $\geq$ p ist. Der Phasenschieber 10 bewirkt dann bei seiner Betätigung (S2I = 1) eine p-fache Verzögerung der an den Phasenmesser 3 abgegebenen Impulse (Verzögerung um $\frac{p}{fa}$, entsprechend p Perinden der Ausgangsfrequenz fa).

Bei einer Weiterbildung des ersten Ausführungsbeispieles wird dem die zweite Summe S2 bildenden zweiten Summierer 16 ein konstanter Wert D zugeführt. (Eingang D). Da die spektrale Verteilung der vom Phasenschieber 10 verursachten hochfrequenten Störlinien von der Phasenlage der ihn triggernden Impulse abhängt, kann je nach Wahl einer gewünschten Ausgangsfrequenz fa die Addition der Konstanten D vorteilhaft sein.

Eine andere Weiterbildung der in den Figuren 3 und 5 dargestellten Anordnungen sieht den Ausgleich von durch die Struktur der Logik- und Rechenschaltung bedingten Laufzeitunterschieden zwischen den beiden Summier- und Weichenschaltungen 13,14,15 und 16,17,18 durch Einfügen eines weiteren getakteten Zwischenspeichers 14' zwischen den Ausgang der Weiche 15 für den ganzzahligen Anteil S1I und den Eingang des Impulssubtrahierers 7 (Fig. 3) bzw. den Eingang des Summierers 20 (Fig. 5) vor.

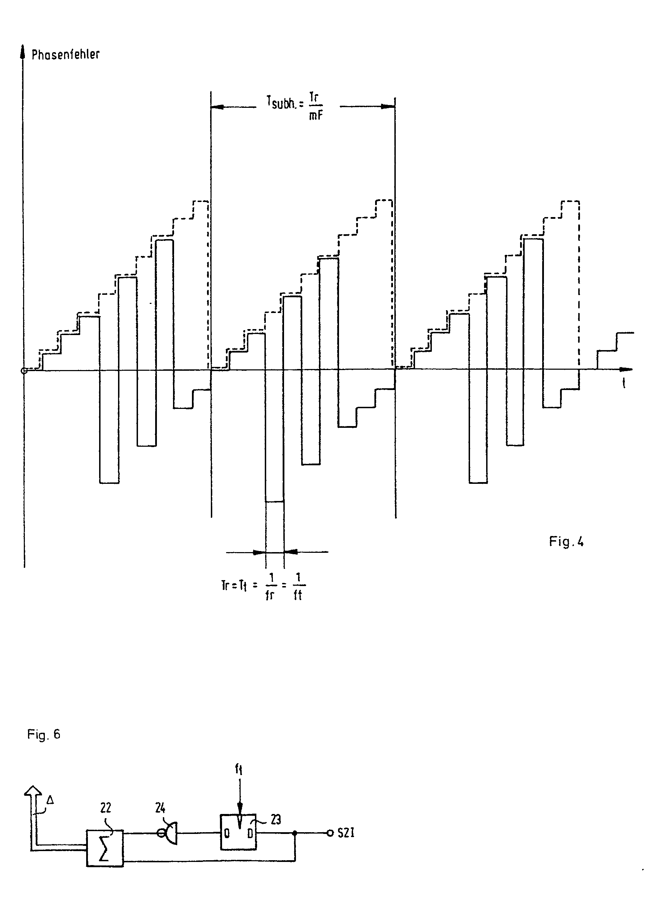

In Figur 4 ist ein dem Phasenfehler der am Eingang des Phasenmessers 3 liegenden Impulse entsprechender möglicher Verlauf der vom Ausgang des Phasenmessers 3 abgegebenen (ungefilterten) VCO-Steuerspannung dargestellt. Im Beispiel ist angenommen, daß der gebrochene Anteil mF des gebrochenen Frequenzteilungsverhältnisses fa:fr = ml + mF gleich einem Zehntel der Referenzfrequenz fr ist, die der Stufung der Ausgangsfrequenz fa beim Verändern des ganzzahligen Frequenzteilungsverhältnisses ml um eine Einheit entspricht und daß die Startwerte der Zwischenspeicher 14,17 jeweils Null sind. Beispielsweise ist bei fa = 14,1 MHz und fr = 1 MHz der Wert von mI = 14 und der Wert von mF = 0,1 = 1 : 10. Ohne die Wirkung der zweiten getakteten Schaltungsgruppe 16,17,18, die den Phasenschieber 10 betätigt, würde sich der gestrichelt gezeichnete Spannungsverlauf 19, d.h. eine sehr tieffrequente, bezüglich der Taktfrequenz ft subharmonische Spannungsschwankung ergeben. Bei Betätigung des Phasenschiebers 10 durch die zweite getaktete Schaltungsgruppe 16,17,18, die immer dann erfolgt, wenn S2I = 1 (bzw. = p) ist, ergibt sich der ausgezogen dargestellte Spannungsverlauf der Ausgangsspannung des Phasenmessers 3, der wesentlich höherfrequente Anteile enthält und der daher wesentlich leichter geglättet werden kann als die Schwebung 19.

Das in Figur 5 dargestellte zweite Ausführungsbeispiel unterscheidet sich von der in Figur 3 dargestellten Anordnung im wesentlichen dadurch, daß es keinen besonderen Phasenschieber aufweist und daß das Frequenzteilungsverhältnism des Frequenzteilers 6' ständig flink umgestellt wird. Als Einstellvorrichtung (20) dient ein Summierer, dem einerseits der ganzzahlige Anteil mI des Frequenzteilungsverhältnisses m', dem andererseits der ganzzahlige Wert S1I der ersten Summe S1 und dem außerdem von einer Differenzierschaltung 21 das "Differential" Δ des ganzzahligen Wertes S2I der zweiten Summe S2 zugeführt ist. Dieses Differential Δ ist Null, wenn der ganzzahlige Wert S2I der zweiten Summe S2 am Beginn einer neuen Taktperiode nicht springt (beim Wert 0 oder beim Wert 1 verbleibt), und er ist +1 bzw. -1, wenn S2I einen positiven Sprung (0→1) bzw. einen negativen Sprung (1→0) ausführt. Die Differenzierschaltung 21 kann also dreierlei Zahlenwerte (-1, 0, +1) an den Summierer 20 abgeben, und letzterer kann, je nach dem der ganzzahlige Anteil S1I der ersten Summe S1 den Wert 0 oder den Wert 1 aufweist, den Frequenzteiler 6' auf viererlei verschiedene Werte (m-1, m, m+1 und m+2) einstellen. Der letzte der drei Summanden (das Differential Δ ) bewirkt aber im zeitlichen Mittel keine Veränderung des durch die beiden ersten Summanden bestimmten mittleren Frequenzteilungsverhältnisse m', sondern lediglich eine Phasenverschiebung eines am Ausgang des Frequenzteilers 6' erscheinenden Impulses.

Die in Figur 6 dargestellte Differenzierschaltung (2 in Fig. 5) enthält einen Summierer 22, der an seinem Ausgang das Differential Δ abgibt. Der ganzzahlige Anteil S2I der zweiten Summe S2 liegt unmittelbar an einem ersten Eingang des Summierers 22 und am Eingang eines mit der Referenzfrequenz ft getakteten D-Flipflops 23. Eine Umkehrschaltung 24 negiert das Ausgangssignal Q und legt es an einen zweiten Eingang des Summierers 22.

Ein viertes und ein fünftes Ausführungsbeispiel ergibt sich jeweils durch Ergänzen der in Figur 3 bzw. in Figur 5 dargestellten Anordnung mit dem dort gestrichelt gezeichneten Schaltungsteil, der der Erzeugung einer Kompensationsspannung U$_K$ dient. Dieser Schaltungsteil 25 bzw. 26 ist in Figur 7 näher dargestellt. In beiden Fällen ist zwischen den Eingang B der Summierschaltung 13, dem die Weichenschaltung 15 den gebrochenen Anteil S1F zuführt, und dem Eingang B' der Summierschaltung 16 eine erste Quantisierschaltung 27 eingefügt. Diese quantisiert den gebrochenen Anteil S1F der in der vorhergehenden Taktperiode ermittelten ersten Summe S1 mit der Stufenhöhe b1 (S1F = Q1I + Q1F = Q1I + S1F mod b1) und leitet den ersten Stufenwert Q1I zur Bildung der zweiten Summe S2 dem Eingang B' des Summierers 16 und den ersten Restwert Q1F einer zweiten Quantisierschaltung 28 zu. Diese quantisiert den gebrochenen Anteil Q1F mit der Stufenhöhe b2 (Q1F = Q2I + Q2F = Q2I + Q1F mod b2) und leitet den zweiten Stufenwert Q2I zur Bildung einer dritten Summe S3 einer dritten Summier- und Weichenschaltung 29,30,31 zu. Sie bildet die dritte Summe S3 aus dem in der vorhergehenden Taktperiode in ihr aufgetretenen gebrochenen Anteil S3F und aus dem in der vorhergehenden Taktperiode aufgetretenen zweiten Stufenwert Q2I, zerlegt sie in den dritten gebrochenen Anteil S3F und einen dritten ganzzahligen Anteil S3I und bildet aus letzterem mit Hilfe eines ersten Digital/Analogwandlers 32 eine proportionale Analogspannung Uk1, die als Teil einer Kompensationsspannung U$_K$ zusammen mit der Steuerspannung dem elektronisch abstimmbaren Oszillator 1 zugeführt wird.

Der zweite Restwert Q2F der zweiten Quantisierschaltung 28 wird einer dritten Quantisierschaltung 33 mit der Stufenhöhe b3 zugeleitet, die ihn in einen dritten, im Beispiel der Figur 5 nicht weiter verarbeiteten Restwert Q3F und in einen dritten Stufenwert Q3I aufteilt. In einer vierten, der dritten ähnlichen Summier- und Weichenschaltung 34,35,36 wird aus dem in der vorhergehenden Taktperiode in ihr aufgetretenen vierten gebrochenen Anteil S4F und aus dem ebenfalls in der vorhergehenden Taktperiode aufgetretenen dritten Stufenwert Q3F eine vierte Summe S4 gebildet und in einen vierten gebrochenen Anteil S4F und in einen vierten ganzzahligen Anteil S4I zerlegt, den ein zweiter Digital/Analogwandler 37 in eine weitere proportionale Analogspannung Uk2 umwandelt. Die beiden Analogspannungen Uk1 und Uk2 werden jeweils frequenzbewertet und zusammen mit der vom Phasenmesser 3 erzeugten Steuerspannung Ust dem elektronisch abstimmbaren Oszillator 1 zugeführt.

Die Teilschaltungen 28 bis 37 stellen insgesamt einen Digital-Analog-Wandler dar, bei dem durch erhöhten Aufwand auf der Digitalseite der Aufwand auf der Analogseite vermindert ist. Der gebrochene Anteil Q1F ist hoch aufgelöst und wird über viele Parallel-Leitungen übertragen, wogegen für die Übertragung der ganzzahligen Anteile S3I und S4I jeweils nur eine Leitung benötigt wird, weil es sich dort um nur zweiwertige Signale handelt, wodurch auch die D/A-Wandler 32 und 37 äußerst einfach werden.

**Patentansprüche**

1. Generator mit digitaler Frequenzeinstellung (Synthesizer) mit einer Phasenregelschleife (PLL), in der ein elektronisch abstimmbarer Oszillator (1) das Ausgangssignal mit der Ausgangsfrequenz fa erzeugt und seine Steuerspannung über ein Schleifenfilter (8) von einem Phasendetektor (3) empfängt, dem zwei Signale zugeführt sind, von denen das erste Signal die hochgenaue Referenzfrequenz fr aufweist und von denen das zweite Signal vom Ausgangssignal des Oszillators (1) über eine frequenzteilende Anordnung (6) mit einstellbarem Teilungsverhältnis m abgeleitet ist,
bei dem ein zur Erzeugung der gewünschten Ausgangsfrequenz fa erforderliches, im allgemeinen gebrochenes Teilungsverhältnis $m' =$ fa : fr = mI + mF durch Einstellen des Teilungsverhältnisses m der Anordnung (6) auf eine einem ganzzahligen Anteil mI des Teilungsverhältnisses m' entsprechende Grundeinstellung m = mI und durch vorübergehendes Umstellen des Teilungsverhältnisses m der Anordnung (6) auf einen Wert m = mI + 1 verwirklicht wird, welche dann stattfindet, wenn in einer vorhergehenden Taktperiode

ein ganzzahliger Anteil S1I einer ersten Summe S1 = S1I + S1F, die im Takt der am Ausgang der Anordnung (6) erscheinenden Impulse aus dem gebrochenen Anteil mF des Teilungsverhältnisses m' und einem in der jeweils vorhergehenden Taktperiode ermittelten gebrochenen Anteil S1F' gebildet wird, den Wert 1 annimmt, so daß die Ausgangsspannung des phasendetektors (3) sägezahnförmig schwankt,
und bei dem diese Schwankung unterdrückt wird,
dadurch gekennzeichnet,
daß im Takt der am Ausgang der Anordnung (6) erscheinenden Impulse eine (zweite) phasenfehlersumme S2 = S2I + S2F aus den beiden in der vorhergehenden Taktperiode ermittelten gebrochenen Anteilen S1F' der ersten Summe S1' und S2F' der zweiten Phasenfehlersumme S2 gebildet wird (S2 = S1F' + S2F')

und daß ein am Ausgang der Anordnung (6) erscheinender Impuls um den festen Phasenwert S2I verzögert wird, wenn die ermittelte Phasenfehlersumme den festen Phasenwert erreicht oder überschreitet, wobei entsprechend bei den oben definierten Größen der Zusatz I ganzzahlige und der Zusatz F gebrochene Anteile angibt.

2. Generator nach Anspruch 1, dadurch gekennzeichnet, daß der am Ausgang der Anordnung (6) erscheinende Impuls um p.Ta verzögert wird, wenn der ganzzahlige Anteil S2I den Wert p aufweist, oder den Impuls nicht verzögert, wenn S2I Null ist (p = ganzzahlig und positiv; Ta = 1/fa).

3. Generator nach Anspruch 2, **dadurch gekennzeichnet,** daß zwischen den Ausgang der anderen (einstellbaren) frequenzteilenden Anordnung (6,7) und den einen Eingang des Phasenmessers (3) ein einstellbarer Phasenschieber (10) geschaltet ist, der aus einem mit der Ausgangsfrequenz fa des Oszillators (1) getakteten mehrstufigen Schieberegister und aus einem Umschalter besteht, der den einen Eingang des Phasenmessers (3) wahlweise mit einem der Ausgänge zweier um den Wert p auseinanderliegender Stufen des Schieberegisters verbindet, und daß die Logik- und Rechenschaltung (2') den Umschalter so betätigt, daß er den Phasenschieber auf seinen kleineren Wert einstellt, wenn die zweite Summe S2 kleiner als ein bestimmter Phasenwert p$2\pi$ ist, und den Phasenschieber auf einen um p$2\pi$ größeren Wert einstellt, wenn die zweite Summe S2 den bestimmten Phasenwert erreicht oder überschritten hat.

4. Generator nach Anspruch 2, **dadurch gekennzeichnet,** daß die Logik- und Rechenschaltung (2') zwecks Verzögerung eines zum Eingang des Phasenmessers (3) gelangenden Impulses das Frequenzteilungsverhältnis m der anderen frequenzteilenden Anordnung (6') gegenüber dem sich aus dem Wert des ganzzahligen Anteiles S1I der ersten Summe S1 ergebenden Wert mI bzw. mI + 1 jeweils einmal während der ersten von zwei aufeinanderfolgenden Perioden ihrer Ausgangsfrequenz ft um eine Einheit erhöht und während der zweiten Periode um eine Einheit erniedrigt (mI + 1 und mI-1 bzw. mI + 2 und mI).

5. Generator nach Anspruch 2, **dadurch gekennzeichnet,** daß der gebrochene Anteil S1F der in der vorhergehenden Taktperiode ermittelten ersten Summe S1 mit der Stufenhöhe

b1 quantisiert wird (S1F = Q1I + Q1F = Q1I + S1F mod b1), daß die zweite Summe S2 aus dem ersten Stufenwert Q1I und dem gebrochenen Anteil S2F der in der vorhergehenden Taktperiode ermittelten zweiten Summe S2 gebildet wird, daß der erste Restwert Q1F mit der Stufenhöhe b2 quantisiert wird (Q1F = Q2I + Q2F = Q2I + Q1F mod b2), daß eine dritte Summe S3 im Takt der am Ausgang der anderen frequenzteilenden Anordnung (6 bzw. 6') erscheinenden Impulse aus dem zweiten Stufenwert Q2I des ersten Restwertes Q1F und einem in der vorhergehenden Taktperiode ermittelten dritten gebrochenen Anteil S3F gebildet wird, der durch Zerlegen der in der vorhergehenden Taktperiode gebildeten dritten Summe S3 in einen dritten ganzzahligen Anteil S3I und den dritten gebrochenen Anteil S3F gebildet wird, daß aus dem dritten ganzzahligen Anteil S3I eine proportionale Analogspannung $U_{K1}$ gebildet und als Kompensationsspannung zusammen mit der Steuerspannung $U_{st}$ dem elektronisch abstimmbaren Oszillator (1) zugeführt wird.

6. Generator nach Anspruch 5, **dadurch gekennzeichnet,** daß der zweite Restwert Q2F mit der Stufenhöhe b3 quantisiert wird (Q2F = Q3I + Q3F = Q3I + Q2F mod b3), daß eine vierte Summe S4 im Takt der am Ausgang der anderen frequenzteilenden Anordnung (6 bzw. 6') erscheinenden Impulse aus dem dritten Stufenwert Q3I des zweiten Restwertes Q2F und einem in der vorhergehenden Taktperiode ermittelten vierten gebrochenen Anteil S4F gebildet wird, der durch Zerlegen der in der vorhergehenden Taktperiode gebildeten vierten Summe S4 in einen vierten ganzzahligen Anteil S4I und den vierten gebrochenen Anteil S4F gebildet wird, daß aus dem vierten ganzzahligen Anteil S4I eine proportionale Analogspannung $U_{K2}$ gebildet und als Kompenationsspannung zusammen mit der Analogspannung $U_{K1}$ und der Steuerspannung $U_{st}$ dem elektronisch abstimmbaren Oszillator (1) zugeführt wird.

7. Generator nach Anspruch 2, **dadurch gekennzeichnet,** daß die andere frequenzteilende Anordnung aus einem beliebig einstellbaren Frequenzteiler (6') und aus einer Einstellvorrichtung (20) für diesen besteht, die dessen Frequenzteilungsverhältnis m abwechselnd auf unterschiedliche einer Vielzahl von Werten einzustellen gestattet.

8. Generator nach Anspruch 2, **dadurch gekennzeichnet,** daß die andere frequenzteilende Anordnung aus einem beliebig einstellbaren Frequenzteiler (6), der auf den Wert m = mI eingestellt wird, und aus einer diesem vorgeschalteten steuerbaren Impulsbewertungsschaltung (7) (Impulssubtrahierer oder Impulsaddierer) besteht, die betätigt wird, wenn der ganzzahlige Anteil S1I den Wert p aufweist.

9. Generator nach Anspruch 7 oder 8, **dadurch gekennzeichnet,** daß zwischen den Ausgang der ersten Weiche (15) für den ganzzahligen Anteil S1I der ersten Summe S1 und den Eingang des Impulssubtrahierers (7, Fig. 3) bzw. den Eingang des Summierers (20, Fig. 5) ein weiterer, mit der Ausgangsfrequenz ft der zweiten frequenzteilenden Anordnung (6,7 in Fig. 3 bzw. 6' in Fig. 5) getakteter Zwischenspeicher (14') (D-Flipflop) geschaltet ist.

10. Generator nach Anspruch 2, **dadurch gekennzeichnet,** daß zur zweiten Summe S2 ein konstanter Wert D addiert wird.

## Claims

1. Generator with digital frequency adjustment (synthesizer), comprising a phase locked loop (PLL), in which a variable-frequency oscillator (1) produces the output signal with the output frequency fa and receives its control voltage from a phase detector (3) via a loop filter (8), two signals being supplied to said detector, the first signal of which has the highly accurate reference frequency fr, and the second signal of which is derived from the output signal of the oscillator (1) via a frequency-divider arrangement (6) with an adjustable ratio of division m, wherein a generally fractional ratio of division m' = fa : fr = mI + mF, which is required to produce the desired output frequency fa, is achieved by setting the ratio of division m of the arrangement (6) to a basic setting m = mI, which corresponds to an integer mI of the ratio of division m', and by temporarily changing the ratio of division m of the arrangement (6) to a value m = mI + 1, such setting occurring when an integer S1I of a first sum S1 = S1I + S1F, which is formed, in synchronism with the pulses appearing at the output of the arrangement (6), from the fraction mF of the ratio of division m' and from a fraction S1F', which is determined in the respective preceding time period, assumes the value 1 in a preceding time period, so that the output voltage of the phase detector (3) fluctuates in a saw-tooth-shaped manner, and wherein this fluctuation is suppressed, characterised in that, in synchronism with the pulses appearing at the output of the arrangement (6), a (second) phase error sum S2 = S2I + S2F is formed from the two fractions S1F' of the first sum S1' and S2F' of the second phase error sum S2 (S2 = S1R' + S2F'), which fractions are determined in the preceding time period, and in that a pulse, which appears at the output of the arrangement (6), is delayed by the fixed phase value S2I when the determined phase error sum reaches or exceeds the fixed phase value, wherein, with the above-defined parameters, the addition I accordingly produces integers, and the addition F accordingly produces fractions.

2. Generator according to claim 1, characterised in that the pulse, which appears at the output of the arrangement (6), is delayed by p.Ta when the integer S2I has the value p, or the pulse is not delayed when S2I is zero (p = integer and positive; Ta = 1/fa).

3. Generator according to claim 2, characterised in that an adjustable phase shifter (10) is connected between the output of the other (adjustable) frequency-divider arrangement (6, 7) and one input of the phasemeter (3), said phase shifter comprising a multi-stage shift register, which is synchronized with the output frequency fa of the oscillator (1), and a changeover switch, which selectively connects one input of the phasemeter (3) to one of the outputs of two stages of the shift register, which stages are separated by the value p, and in that the logic and calculating circuit (2') actuates the changeover switch in such a manner that it sets the phase shifter to its smaller value when the second sum S2 is smaller than a predetermined phase value p2$\pi$, and it sets the phase shifter to a value greater by p2$\pi$ when the second sum S2 reaches or has exceeded the predetermined phase value.

4. Generator according to claim 2, characterised in that, for the purpose of delaying a pulse passing to the input of the phasemeter (3), the logic and calculating circuit (2') increases the ratio of frequency division m of the other frequency-divider arrangement (6') relative to the value ml or ml + 1 respectively, resulting from the value of the integer S1I of the first sum S1, once during the first of two successive periods of its output frequency ft by one unit and lowers such during the second period by one unit (ml + 1 and ml-1 or ml + 2 and ml).

5. Generator according to claim 2, characterised in that the fraction S1F of the first sum S1, which is determined in the preceding time period, is quantized at the stage level b1 (S1F = Q1I + Q1F = Q1I + S1F mod b1), in that the second sum S2 is formed from the first stage value Q1I and from the fraction S2F of the second sum S2, which is determined in the preceding time period, in that the first residual value Q1F is quantised at the stage level b2 (Q1F = Q2I + Q2F = Q2I + Q1F mod b2), in that a third sum S3, in synchronism with the pulses appearing at the output of the other frequency-divider arrangement (6 or 6'), is formed from the second stage value Q2I of the first residual value Q1F and from a third fraction S3F, which is determined in the preceding time period and is formed by splitting the third sum S3, formed in the preceding time period, into a third integer S2I and the third fraction S3F, in that a proportional analog voltage $U_{k1}$ is formed from the third integer S3I and is supplied to the variable-frequency oscillator (1) as a compensation voltage together with the control voltage $U_{st}$.

6. Generator according to claim 5, characterised in that the second residual value Q2F is quantized at the stage level b3 (Q2F = Q3I + Q3F = Q3I + Q2F mod b3), in that a fourth sum S4, in synchronism with the pulses appearing at the output of the other frequency-divider arrangement (6 or 6'), is formed from the third stage value Q3I of the second residual value Q2F and from a fourth fraction S4F, which is determined in the preceding time period and is formed by splitting the fourth sum S4, formed in the preceding time period, into a fourth integer S4I and the fourth fraction S4F, in that a proportional analog voltage $U_{k2}$ is formed from the fourth integer S4I and is supplied to the variable-frequency oscillator (1) as a compensation voltage together with the analog voltage $U_{k1}$ and the control voltage $U_{st}$.

7. Generator according to claim 2, characterised in that the other frequency-divider arrangement comprises a frequency divider (6'), which is adjustable as desired, and an adjusting device (20) which serves to adjust said frequency divider and permits the ratio of frequency division m of said frequency divider to be set alternately to different values from a plurality of values.

8. Generator according to claim 2, characterised in that the other frequency-divider arrangement comprises a frequency divider (6), which is adjustable as desired and is set to the value m = ml, and a controllable pulse evaluation circuit (7) (pulse subtractor or pulse adder), which is connected at the input of said frequency divider and is actuated when the integer S1I has the value p.

9. Generator according to claim 7 or 8, characterised in that an additional temporary storage unit (14') (D-flipflop), which is synchronized with the output frequency ft of the second frequency-divider arrangment (6, 7 in Fig. 3, or 6' in Fig. 5), is connected between the output of the first duplexor (15) for the integer S1I of the first sum S1 and the input of the pulse subtractor (7, Fig. 3) or the input of the summing device (20, Fig. 5).

10. Generator according to claim 2, characterised in that a constant value D is added to the second sum S2.

**Revendications**

1. Générateur à réglage numérique de fréquence (synthétiseur) comportant une boucle de régulation de phase (PLL) dans laquelle un oscillateur (1) pouvant être accordé electroniquement produit le signal de sortie ayant la fréquence de sortie fa et reçoit sa tension de commande, par l'intermédiaire d'un filtre de boucle (8), à partir d'un détecteur de phase (3) auquel sont amenés deux signaux dont le premier signal présente la fréquence de référence très précise fr et dont le second signal dérive du signal de sortie de l'oscillateur (1) par l'intermédiaire d'un dispositif de division de fréquence (6) ayant un rapport de division m réglable,

dans lequel un rapport de division, généralement fractionnaire, m' = fa : fr = mI + mF, nécessaire pour produire la fréquence de sortie désirée fa, est concrétisé par un réglage du rapport de division m du dispositif (6) sur une valeur de base m = mI correspondant à une partie entière mI du rapport de division m' et par un changement provisoire du rapport de division m du dispositif (6) sur une valeur m = mI + 1,

ce qui se produit, lorsqu'au cours d'une période d'impulsions d'horloge précédente, une partie entière S1I d'une première somme S1 = S1I + S1F qui, au rythme des impulsions apparaissant à la sortie du dispositif (6), est formée d'une partie fractionnaire mF du rapport de division m' et d'une partie fractionnaire S1F' établie lors de chacune des périodes d'impulsions d'horloge précédentes, prend la valeur 1, de sorte que la tension de sortie du détecteur de phase (3) oscille en dents de scie,

et dans lequel cette oscillation est supprimée,

caractérisé en ce

qu'au rythme des impulsions apparaissant à la sortie du dispositif (6), il se forme une (seconde) somme d'erreurs de phase S2 = S2I + S2F constituée des deux parties fractionnaires déterminées au cours de la période d'impulsions d'horloge précédente, S1F' de la première somme S1' et S2F' de la seconde somme d'erreurs de phase S2 (S2 = S1F' + S2F')

et en ce qu'une impulsion apparaissant à la sortie du dispositif (6) est retardée de la valeur de phase fixe S2I lorsque la somme des erreurs de phase ainsi établie atteint ou dépasse la valeur de phase fixe, étant précisé que dans le cas de valeurs définies ci-dessus, l'indice I indique des parties entières et l'indice F indique des parties fractionnaires.

2. Générateur selon la revendication 1, caractérisé en ce que l'impulsion apparaisant à la sortie du dispositif (6) est retardée de p.Ta lorsque la partie entière S2I présente la valeur p, ou en ce que l'impulsion n'est pas retardée lorsque S2I est nulle (p = entier positif; Ta = 1/fa).

3. Générateur selon la revendication 2, caractérisé en ce qu'entre la sortie de l'autre dispositif de division de fréquence (réglable) (6,7) et la première entrée du phasemètre (3) est branché un déphaseur réglable (10) constitué d'un registre à décalage à plusieurs étages activé par la fréquence de sortie fa de l'oscillateur (1) et d'un convertisseur reliant, au choix, la première entrée du phasemètre (3) avec l'une des sorties de deux étages éloignés l'un de l'autre de la valeur p, et en ce que le circuit logique et de calcul (2') actionne le convertisseur de façon qu'il règle le déphaseur sur sa plus petite valeur lorsque la seconde somme S2 est inférieure à une valeur de phase déterminée p2 π et qu'il règle le déphaseur sur une valeur plus grande de p2 π lorsque la seconde somme S2 a atteint ou dépassé la valeur de phase déterminée.

4. Générateur selon la revendication 2, caractérisé en ce que, dans le but de retarder une impulsion qui parvient à l'entrée du phasemètre (3), le circuit logique et de calcul (2') accroît d'une unité, pendant chaque première période de deux périodes successives de sa fréquence de sortie ft, le rapport de division de fréquence m de l'autre dispositif diviseur de fréquence (6') par rapport à la valeur mI ou mI + 1 résultant de la valeur de la partie entière S1I de la première somme S1 et, l'abaisse d'une unité pendant la seconde période, (ml + 1 et ml-1 ou ml + 2 et ml).

5. Générateur selon la revendication 2, caractérisé en ce que la partie fractionnaire S1F de la première somme S1, déterminée au cours de la période d'impulsion d'horloge précédente, est quantifiée avec la hauteur de gradin b1 (S1F = Q1I + Q1F = Q1I + S1F mod b1), en ce que la seconde somme S2 est formée de la première valeur de gradin Q1I et de la partie fractionnaire S2F de la seconde somme S2 déterminée au cours de la période d'impulsions d'horloge précédente, en ce que la première valeur résiduelle Q1F est quantifiée avec la hauteur de gradin b2 (Q1F = Q2I + Q2F = Q2I + Q1F mod b2), en ce qu'une troisième somme S3 est formée, au rythme des impulsions apparaissant à la sortie de l'autre dispositif diviseur de fréquence (6 ou 6'), de la seconde valeur de gradin Q2I de la première valeur résiduelle Q1F et d'une troisième partie fractionnaire S3F' déterminée au cours de la période d'impulsions d'horloge précédente et formée par décomposition de la troisième somme S3 formée au cours de la période d'impulsions d'horloge précédente, en une troisième partie entière S3I et en la troisième partie fractionnaire S3F, en ce qu'une tension analogique proportionnelle $U_{K1}$ est formée à partir de la troisième partie entière S3I et envoyée, en tant que tension de compensation, à l'oscillateur (1) pouvant être accordé électroniquement, en même temps que la tension de commande $U_{st}$.

6. Générateur selon la revendication 5, caractérisé en ce que la seconde valeur résiduelle Q2F est quantifiée avec la hauteur de gradin b3 (Q2F = Q3I + Q3F = Q3I + Q2F mod b3), en ce qu'une quatrième somme S4 est formée, au rythme des impulsions apparaissant à la sortie de l'autre dispositif diviseur de fréquence (6 ou 6'), à partir de la troisième valeur de gradin Q3I de la seconde valeur résiduelle Q2F et à partir d'une quatrième partie fractionnaire S4F déterminée au cours de la période d'impulsions d'horloge précédente et formée par décomposition de la quatrième somme S4, formée au cours de la période d'impulsions d'horloge précédente, en une quatrième partie entière S4I et en la quatrième partie fractionnaire S4F, en ce qu'une tension analogique proportionnelle $U_{K2}$ est formée à partir de la quatrième partie entière S4I et envoyée, en tant que tension de compensation, à l'oscillateur (1) pouvant être accordé électroniquement, en même temps que la tension analogique $U_{K1}$ et que la tension de commande $U_{st}$.

7. Générateur selon la revendication 2, caractérisé en ce que l'autre dispositif diviseur de fréquence est constitué d'un diviseur de fréquence (6') réglable à volonté et, pour ce dernier, d'un dispositif de réglage (20) qui permet de régler alternativement son rapport de division de fréquence m sur différentes valeurs parmi plusieurs valeurs.

8. Générateur selon la revendication 2, caractérisé en ce que l'autre dispositif diviseur de fréquence est constitué d'un diviseur de fréquence (6) réglable à volonté, réglé sur la valeur m = ml, et d'un circuit d'évaluation d'impulsions (7) (soustracteur d'impulsions ou additionneur d'impulsions) monté en amont de celui-ci, qui peut être commandé et qui est actionné lorsque la partie entière S1I présente la valeur p.

9. Générateur selon la revendication 7 ou 8, caractérisé en ce qu'entre la sortie de la première dérivation (15) pour la partie entière S1I de la première somme S1 et l'entrée du soustracteur d'implusions (7, figure 3) ou l'entrée de l'organe de sommation (20, figure 5), est branchée une autre mémoire intermédiaire (14') (bascule bistable D) synchronisée avec la fréquence de sortie ft du second dispositif diviseur de fréquence (6,7 de la figure 3, ou 6' de la figure 5).

10. Générateur selon la revendication 2, caractérisé en ce qu'une valeur constante D est ajoutée à la seconde somme S2.

Fig. 1

Fig. 2

Fig. 3

Phasenfehler

$$T_{subh.} = \frac{Tr}{mF}$$

Fig. 4

$$Tr = Tf = \frac{1}{fr} = \frac{1}{ff}$$

Fig. 6

ff

22    24    23    SZI

Δ

11

Fig. 5

Fig. 7